# EUROPEAN PATENT APPLICATION

(11) **EP 4 845 321 A1**
(43) Date of publication of application: **25.11.2026**
(21) Application number: 25197000.0
(22) Date of filing: 20.08.2025
(51) Int. Cl.: H05K 7/14

(54) **SLIDE RAIL MECHANISM**

(30) Priority: 22.05.2025 TW 114119567
(71) Applicant: King Slide Works Co., Ltd., Kaohsiung City (TW); King Slide Technology Co., Ltd., Kaohsiung City (TW)
(72) Inventor: CHEN, Ken-Ching, Kaohsiung City (TW); YANG, Shun-Ho, Kaohsiung City (TW); CHANG, Wei-Chen, Kaohsiung City (TW); WANG, Chun-Chiang, Kaohsiung City (TW)
(74) Representative: Viering, Jentschura & Partner mbB Patent- und Rechtsanwälte

(57) **Abstract**

A slide rail mechanism (20) includes: a first set of slide rail assemblies (21A) that includes a first predetermined rail (L1), a first corresponding rail (L2), a second predetermined rail (R1), and a second corresponding rail (R2); and a second set of slide rail assemblies (21B) that includes a third predetermined rail (La), a third corresponding rail (Lb), a fourth predetermined rail (Ra), and a fourth corresponding rail (Rb). Each of the first corresponding rail (L2), the second predetermined rail (R1), the third predetermined rail (La), and the fourth corresponding rail (Rb) includes a foolproof feature (28/30/32/34) such that the first corresponding rail (L2) can be mounted only to the first predetermined rail (L1), the second corresponding rail (R2) to the second predetermined rail (R1), the third corresponding rail (Lb) to the third predetermined rail (La), and the fourth corresponding rail (Rb) to the fourth predetermined rail (Ra).

## Description

### Field of the Invention

The present invention relates to a slide rail device and more particularly to a slide rail mechanism that has a foolproof mechanism.

### Background of the Invention

Generally, a set of slide rail assemblies includes slide rails on the left and slide rails on the right. Each slide rail on the left can be mounted only to the intended slide rail(s) on the left, and each slide rail on the right can be mounted only to the intended slide rail(s) on the right. In other words, a slide rail on the left cannot be mounted to a slide rail on the right, and vice versa.

For example, US Patent No. 10,973,322 B1 discloses a slide rail assembly in which a blocking feature and a movable foolproof member can work with each other to prevent a second rail from being erroneously mounted into the channel of an unintended first rail, and in which an elastic force is applied to the foolproof member.

As market needs vary, it is an issue worth exploring to develop a slide rail mechanism that includes at least two sets of slide rail assemblies and a foolproof mechanism for preventing erroneous mounting of the slide rails in the multiple sets of slide rail assemblies.

### Summary of the Invention

The objective of the invention is achieved by the subject-matter of the independent claims. Advantageous embodiments are disclosed by the dependent claims.

The present invention relates to a slide rail mechanism with a foolproof mechanism.

According to one aspect of the present invention, a slide rail mechanism is adapted for mounting a first object and a second object to a rack. The rack has a first side and a second side. The slide rail mechanism includes a first set of slide rail assemblies and a second set of slide rail assemblies. The first set of slide rail assemblies includes a first predetermined rail, a first corresponding rail, a second predetermined rail, and a second corresponding rail. The first predetermined rail is configured to be arranged on the first side of the rack. The first corresponding rail includes a first foolproof feature. The second predetermined rail is configured to be arranged on the second side of the rack, and the second predetermined rail includes a second foolproof feature. The second set of slide rail assemblies includes a third predetermined rail, a third corresponding rail, a fourth predetermined rail, and a fourth corresponding rail. The third predetermined rail is configured to be arranged on the first side of the rack, and the third predetermined rail includes a third foolproof feature. The fourth predetermined rail is configured to be arranged on the second side of the rack. The fourth corresponding rail includes a fourth foolproof feature. The first corresponding rail and the second corresponding rail are configured to be arranged on the first object, and the first corresponding rail and the second corresponding rail are configured to be inserted into the first predetermined rail and the second predetermined rail respectively in a detachable manner and to thereby mount the first object to the rack. The third corresponding rail and the fourth corresponding rail are configured to be arranged on the second object, and the third corresponding rail and the fourth corresponding rail are configured to be inserted into the third predetermined rail and the fourth predetermined rail respectively in a detachable manner and to thereby mount the second object to the rack. If the first object is mounted by inserting the first corresponding rail and the second corresponding rail into the third predetermined rail and the fourth predetermined rail respectively, the first foolproof feature of the first corresponding rail and the third foolproof feature of the third predetermined rail will produce a mistake-proofing effect by interfering with each other to prevent the first object from being mounted to the rack.

According to another aspect of the present invention, a slide rail mechanism includes a first set of slide rail assemblies and a second set of slide rail assemblies. The first set of slide rail assemblies includes a first predetermined rail, a first corresponding rail, a second predetermined rail, and a second corresponding rail. The first corresponding rail includes a first foolproof feature, and the first corresponding rail is configured to be used in conjunction with the first predetermined rail. The second predetermined rail includes a second foolproof feature. The second corresponding rail is configured to be used in conjunction with the second predetermined rail. The second set of slide rail assemblies includes a third predetermined rail, a third corresponding rail, a fourth predetermined rail, and a fourth corresponding rail. The third predetermined rail includes a third foolproof feature. The third corresponding rail is configured to be used in conjunction with the third predetermined rail. The fourth corresponding rail includes a fourth foolproof feature, and the fourth corresponding rail is configured to be used in conjunction with the fourth predetermined rail. In the course in which the first corresponding rail is inserted into a channel of the first predetermined rail from outside the channel of the first predetermined rail, the first foolproof feature of the first corresponding rail does not interfere with the first predetermined rail, so the first corresponding rail is allowed to be mounted to the first predetermined rail. If the first corresponding rail is inserted into a channel of the third predetermined rail from outside the channel of the third predetermined rail, the first foolproof feature of the first corresponding rail and the third foolproof feature of the third predetermined rail will produce a mistake-proofing effect by interfering with each other to prevent the first corresponding rail from being mounted to the third predetermined rail.

According to still another aspect of the present invention, a slide rail mechanism includes a first set of slide rail assemblies. The first set of slide rail assemblies includes a first-side slide rail device and a second-side slide rail device. The first-side slide rail device includes: a first corresponding rail including a first foolproof feature; a first stationary rail; and a first predetermined rail movably mounted between the first corresponding rail and the first stationary rail. The second-side slide rail device includes: a second corresponding rail; a second stationary rail; and a second predetermined rail including a second foolproof feature and movably mounted between the second corresponding rail and the second stationary rail. The first corresponding rail and the second corresponding rail are configured to be used in conjunction with the first predetermined rail and the second predetermined rail respectively in a first mounting condition. In a second mounting condition where the predetermined mounting positions of the first corresponding rail and the second corresponding rail are erroneously reversed in terms of left and right, coupling of the first corresponding rail to the second predetermined rail by insertion thereinto is prevented by interference between the first foolproof feature of the first corresponding rail and the second foolproof feature of the second predetermined rail.

The foolproof features ensure that any two slide rails for which the foolproof features are designed will always be mounted accurately with respect to each other. For example, the foolproof features can prevent a slide rail from being mounted to (e.g., inserted into) an unintended slide rail.

### Brief Description of the Drawings

FIG. 1 is a perspective view of an embodiment of the present invention, showing that a first object and a second object are brought into a retracted state with respect to a rack by a slide rail mechanism;
FIG. 2 is another perspective view of the embodiment of the present invention, showing that the first object and the second object are brought into an extended state with respect to the rack by the slide rail mechanism;
FIG. 3 is a schematic drawing of the embodiment of the present invention, showing how the first object is removed from the rack;
FIG. 4 is another schematic drawing of the embodiment of the present invention, showing how the first object is mounted to the rack;
FIG. 5 is yet another schematic drawing of the embodiment of the present invention, showing how the second object is removed from the rack;
FIG. 6 is still another schematic drawing of the embodiment of the present invention, showing how the second object is mounted to the rack;
FIG. 7 is a further schematic drawing of the embodiment of the present invention, showing that the interference between two of the foolproof features of the slide rails of the slide rail mechanism can prevent the first object from being mounted at a wrong position on the rack;
FIG. 8 is yet another schematic drawing of the embodiment of the present invention, showing that the interference between the other two foolproof features of the slide rails of the slide rail mechanism can prevent the second object from being mounted at a wrong position on the rack;
FIG. 9 is a partial perspective view of the embodiment of the present invention, showing that the interference between the two foolproof features of a first corresponding rail and a third predetermined rail of the slide rail mechanism can prevent the first corresponding rail from being erroneously mounted to the third predetermined rail; and
FIG. 10 is another partial perspective view of the embodiment of the present invention, showing that the first corresponding rail can be correctly mounted to a first predetermined rail of the slide rail mechanism because the first predetermined rail does not have a foolproof feature.

### Detailed Description of the Invention

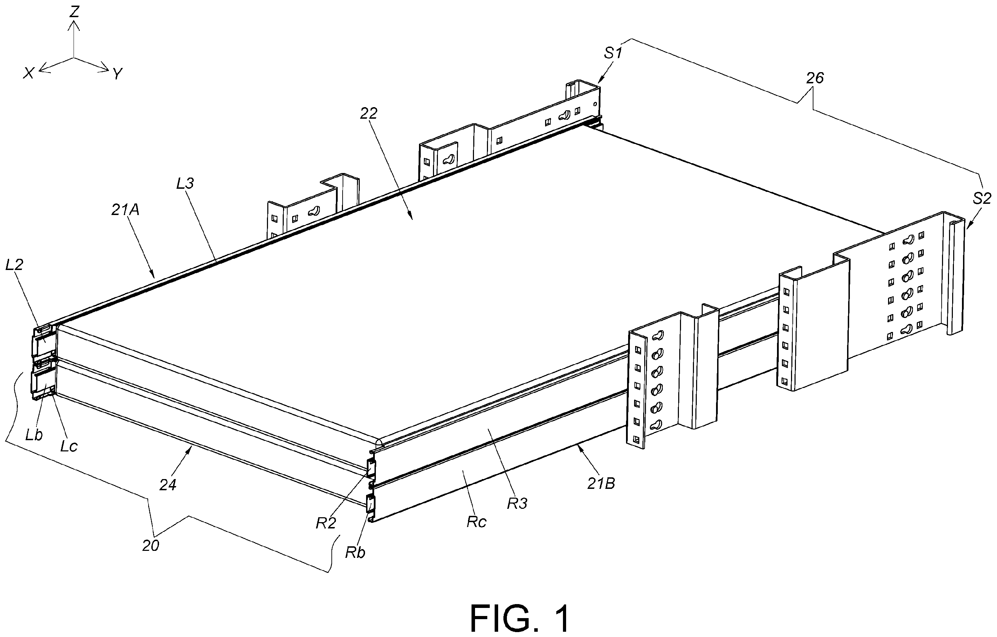

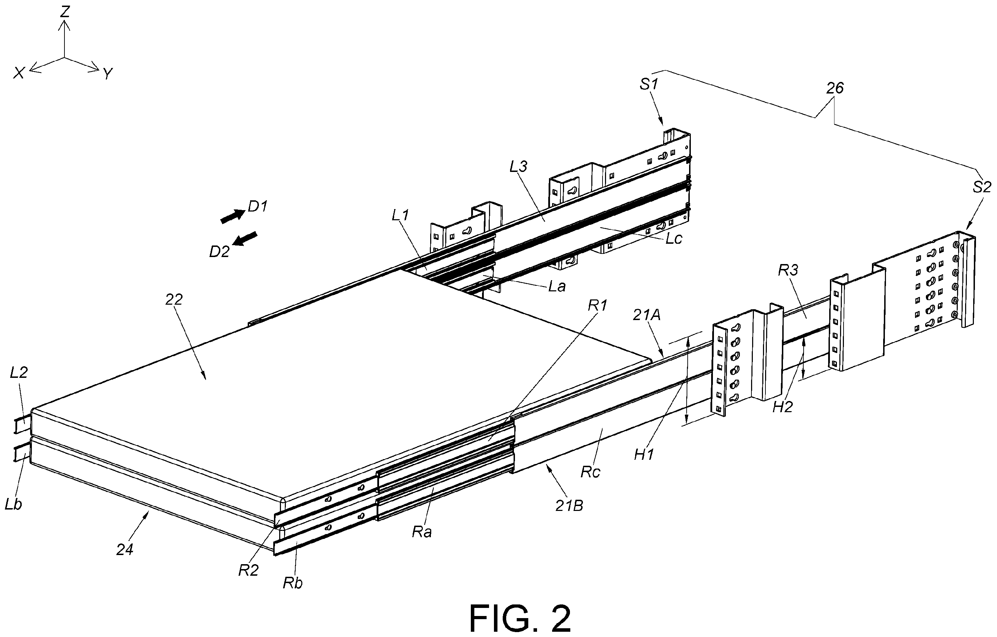

Referring to FIG. 1 and FIG. 2, the slide rail mechanism 20 in an embodiment of the present invention is adapted for mounting a first object 22 and/or a second object 24 to a rack 26 that has a first side S1 and a second side S2. In this embodiment, the first side S1 and the second side S2 are a left side and a right side of the rack 26 respectively; in practice, however, the first side S1 and the second side S2 are not necessarily so defined.

The slide rail mechanism 20 includes a first set of slide rail assemblies 21A and/or a second set of slide rail assemblies 21B. The first set of slide rail assemblies 21A and the second set of slide rail assemblies 21B are configured to be arranged on the rack 26 and each located at a different height of the rack 26. For example, the first set of slide rail assemblies 21A is located at a first height H1, and the second set of slide rail assemblies 21B is located at a second height H2 different from the first height H1. Here, the first height H1 is higher than the second height H2 by way of example; in practice, the first height H1 and the second height H2 are not necessarily so set.

The first set of slide rail assemblies 21A includes a first predetermined rail L1, a first corresponding rail L2, a second predetermined rail R1, and a second corresponding rail R2. Preferably, the first set of slide rail assemblies 21A further includes a first stationary rail L3 and a second stationary rail R3. The first predetermined rail L1, the first corresponding rail L2, and the first stationary rail L3 jointly constitute a first-side slide rail device of the first set of slide rail assemblies 21A (e.g., a left-side slide rail device of the first set of slide rail assemblies 21A). The second predetermined rail R1, the second corresponding rail R2, and the second stationary rail R3 jointly constitute a second-side slide rail device of the first set of slide rail assemblies 21A (e.g., a right-side slide rail device of the first set of slide rail assemblies 21A).

The first predetermined rail L1 is configured to be arranged on the first side S1 of the rack 26. Preferably, the first predetermined rail L1 is arranged on the first side S1 (e.g., the left side), and at the first height H1, of the rack 26 via the first stationary rail L3. More specifically, the first stationary rail L3 is fixed on the first side S1 of the rack 26, the first predetermined rail L1 (e.g., a first left-side middle rail) is movably mounted between the first stationary rail L3 (e.g., a first left-side outer rail) and the first corresponding rail L2 (e.g., a first left-side inner rail), and the first corresponding rail L2 is configured to be connected or mounted to the first object 22. The first predetermined rail L1 and the first corresponding rail L2 can be longitudinally displaced with respect to the first stationary rail L3. Here, the X-axis direction is defined as the longitudinal direction (or the length direction or displacement direction of the slide rails), the Y-axis direction is defined as the transverse direction (or a lateral direction of the slide rails), and the Z-axis direction is defined as the vertical direction (or the height direction of the slide rails or the height direction of the rack).

The second predetermined rail R1 is configured to be arranged on the second side S2 of the rack 26. Preferably, the second predetermined rail R1 is arranged on the second side S2 (e.g., the right side), and at the first height H1, of the rack 26 via the second stationary rail R3. More specifically, the second stationary rail R3 is fixed on the second side S2 of the rack 26, the second predetermined rail R1 (e.g., a first right-side middle rail) is movably mounted between the second stationary rail R3 (e.g., a first right-side outer rail) and the second corresponding rail R2 (e.g., a first right-side inner rail), and the second corresponding rail R2 is configured to be connected or mounted to the first object 22. The first corresponding rail L2 and the second corresponding rail R2 are configured to be arranged on two opposite sides, such as a left side and a right side, of the first object 22 respectively. The second predetermined rail R1 and the second corresponding rail R2 can be longitudinally displaced with respect to the second stationary rail R3.

The second set of slide rail assemblies 21B includes a third predetermined rail La, a third corresponding rail Lb, a fourth predetermined rail Ra, and a fourth corresponding rail Rb. Preferably, the second set of slide rail assemblies 21B further includes a third stationary rail Lc and a fourth stationary rail Rc. The third predetermined rail La, the third corresponding rail Lb, and the third stationary rail Lc jointly constitute a first-side slide rail device of the second set of slide rail assemblies 21B (e.g., a left-side slide rail device of the second set of slide rail assemblies 21B). The fourth predetermined rail Ra, the fourth corresponding rail Rb, and the fourth stationary rail Rc jointly constitute a second-side slide rail device of the second set of slide rail assemblies 21B (e.g., a right-side slide rail device of the second set of slide rail assemblies 21B).

The third predetermined rail La is configured to be arranged on the first side S1 of the rack 26. Preferably, the third predetermined rail La is arranged on the first side S1 (e.g., the left side), and at the second height H2, of the rack 26 via the third stationary rail Lc. More specifically, the third stationary rail Lc is fixed on the first side S1 of the rack 26, the third predetermined rail La (e.g., a second left-side middle rail) is movably mounted between the third stationary rail Lc (e.g., a second left-side outer rail) and the third corresponding rail Lb (e.g., a second left-side inner rail), and the third corresponding rail Lb is configured to be connected or mounted to the second object 24. The third predetermined rail La and the third corresponding rail Lb can be longitudinally displaced with respect to the third stationary rail Lc.

The fourth predetermined rail Ra is configured to be arranged on the second side S2 of the rack 26. Preferably, the fourth predetermined rail Ra is arranged on the second side S2 (e.g., the right side), and at the second height H2, of the rack 26 via the fourth stationary rail Rc. More specifically, the fourth stationary rail Rc is fixed on the second side S2 of the rack 26, the fourth predetermined rail Ra (e.g., a second right-side middle rail) is movably mounted between the fourth stationary rail Rc (e.g., a second right-side outer rail) and the fourth corresponding rail Rb (e.g., a second right-side inner rail), and the fourth corresponding rail Rb is configured to be connected or mounted to the second object 24. The third corresponding rail Lb and the fourth corresponding rail Rb are configured to be arranged on two opposite sides, such as a left side and a right side, of the second object 24 respectively. The fourth predetermined rail Ra and the fourth corresponding rail Rb can be longitudinally displaced with respect to the fourth stationary rail Rc.

It is worth mentioning that the first corresponding rail L2 (together with the first predetermined rail L1) and the second corresponding rail R2 (together with the second predetermined rail R1) can be moved to their respective retracted positions by displacement in a retracting direction D1 with respect to the first stationary rail L3 and the second stationary rail R3 respectively, thereby bringing the first object 22 into a retracted state with respect to the rack 26 (see FIG. 1); and that the third corresponding rail Lb (together with the third predetermined rail La) and the fourth corresponding rail Rb (together with the fourth predetermined rail Ra) can be moved to their respective retracted positions by displacement in the retracting direction D1 with respect to the third stationary rail Lc and the fourth stationary rail Rc respectively, thereby bringing the second object 24 into a retracted state with respect to the rack 26 (see FIG. 1).

Alternatively, the first corresponding rail L2 (together with the first predetermined rail L1) and the second corresponding rail R2 (together with the second predetermined rail R1) can be moved to their respective extended positions by displacement in an opening direction D2 with respect to the first stationary rail L3 and the second stationary rail R3 respectively, thereby bringing the first object 22 into an extended state with respect to the rack 26 (see FIG. 2), and the third corresponding rail Lb (together with the third predetermined rail La) and the fourth corresponding rail Rb (together with the fourth predetermined rail Ra) can be moved to their respective extended positions by displacement in the opening direction D2 with respect to the third stationary rail Lc and the fourth stationary rail Rc respectively, thereby bringing the second object 24 into an extended state with respect to the rack 26 (see FIG. 2).

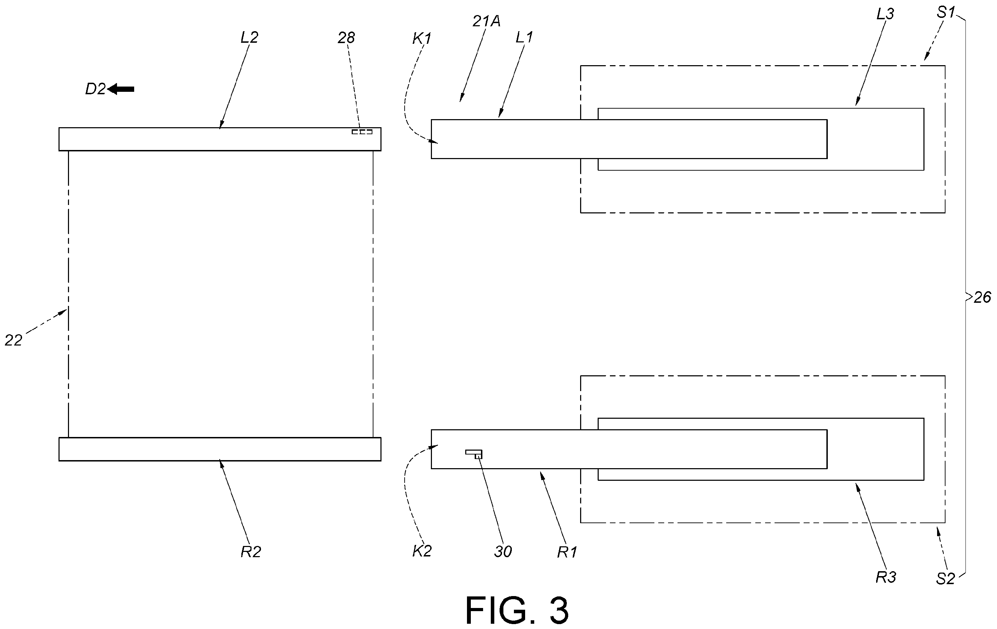

In FIG. 3, the first set of slide rail assemblies 21A is mounted in place along with the first object 22. The first stationary rail L3 is fixed on the first side S1 of the rack 26, and the first predetermined rail L1 is at its extended position with respect to the first stationary rail L3. The second stationary rail R3 is fixed on the second side S2 of the rack 26, and the second predetermined rail R1 is at its extended position with respect to the second stationary rail R3. The first corresponding rail L2 and the second corresponding rail R2 can be detached by being displaced in the opening direction D2 from a first channel K1 of the first predetermined rail L1 and a second channel K2 of the second predetermined rail R1 respectively, such that the first object 22 is removed from the first height H1 of the rack 26. Moreover, the first corresponding rail L2 includes a first foolproof feature 28, and the second predetermined rail R1 includes a second foolproof feature 30.

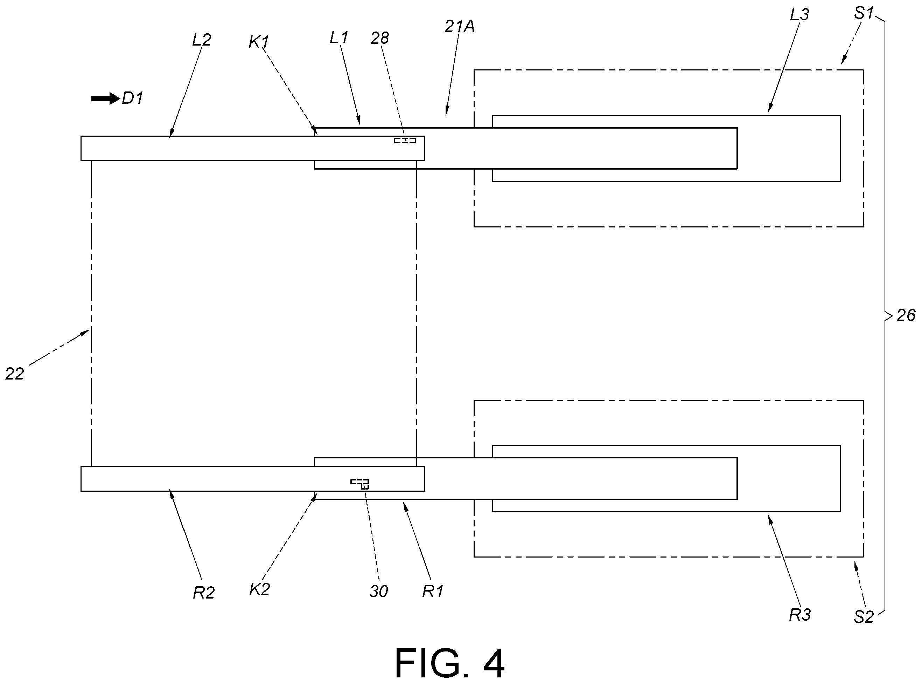

Referring to FIG. 4, the first corresponding rail L2 and the second corresponding rail R2 are configured to be used in conjunction with the first predetermined rail L1 and the second predetermined rail R1 respectively in a normal condition (e.g., in a first mounting condition). More specifically, the first corresponding rail L2 and the second corresponding rail R2 are configured to be inserted, in the retracting direction D1 and in a detachable manner, into the first channel K1 of the first predetermined rail L1 and the second channel K2 of the second predetermined rail R1 from outside the first channel K1 of the first predetermined rail L1 and the second channel K2 of the second predetermined rail R1 respectively, thereby mounting the first object 22 to the rack 26. The inserting operation can continue until the first object 22 is in its retracted state with respect to the rack 26.

FIG. 3 and FIG. 4 show the first set of slide rail assemblies 21A used in conjunction with the first object 22 in a normal mounting condition. It can be understood that when the first set of slide rail assemblies 21A is not yet used with the first object 22 (e.g., when the slide rail products just arrives at the user end from the factory), an abnormal condition (e.g., a second mounting condition) may arise where the user mistakes (e.g., erroneously reverses) the predetermined left and right mounting positions of the first corresponding rail L2 and the second corresponding rail R2 and attempts to mount each of these two rails on the other's designated side. Should that happen, the first foolproof feature 28 of the first corresponding rail L2 and the second foolproof feature 30 of the second predetermined rail R1 will interfere with each other, preventing the first corresponding rail L2 from being inserted into, and hence from being coupled to, the second channel K2 of the second predetermined rail R1. The prevention produces a mistake-proofing and warning effect, alerting the user to the fact that the first set of slide rail assemblies 21A is being mounted erroneously.

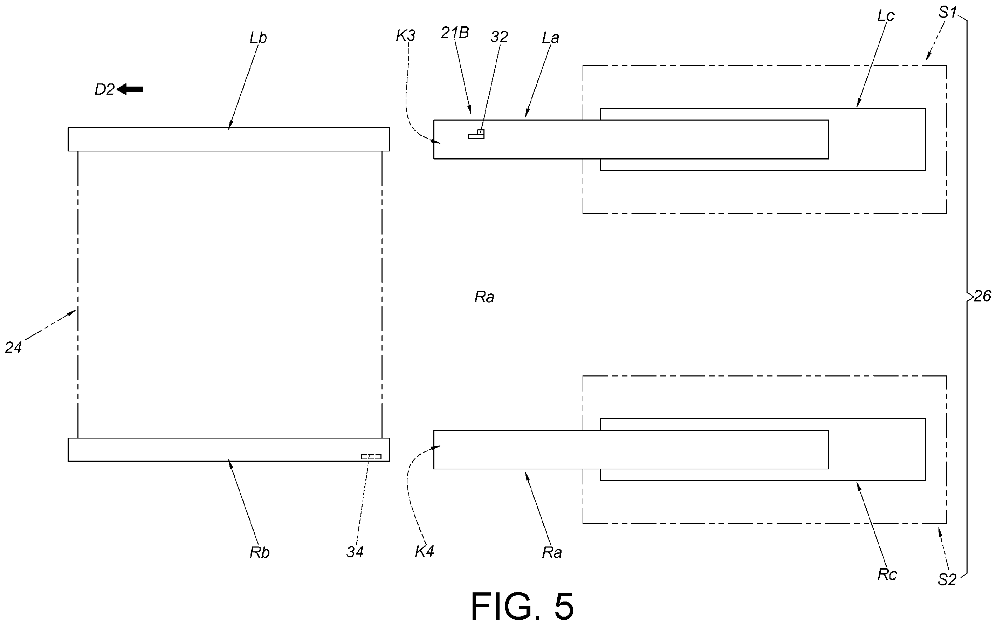

In FIG. 5, the second set of slide rail assemblies 21B is mounted in place along with the second object 24. The third stationary rail Lc is fixed on the first side S1 of the rack 26, and the third predetermined rail La is at its extended position with respect to the third stationary rail Lc. The fourth stationary rail Rc is fixed on the second side S2 of the rack 26, and the fourth predetermined rail Ra is at its extended position with respect to the fourth stationary rail Rc. The third corresponding rail Lb and the fourth corresponding rail Rb can be detached by being displaced in the opening direction D2 from a third channel K3 of the third predetermined rail La and a fourth channel K4 of the fourth predetermined rail Ra respectively, such that the second object 24 is removed from the second height H2 of the rack 26. Moreover, the third predetermined rail La includes a third foolproof feature 32, and the fourth corresponding rail Rb includes a fourth foolproof feature 34.

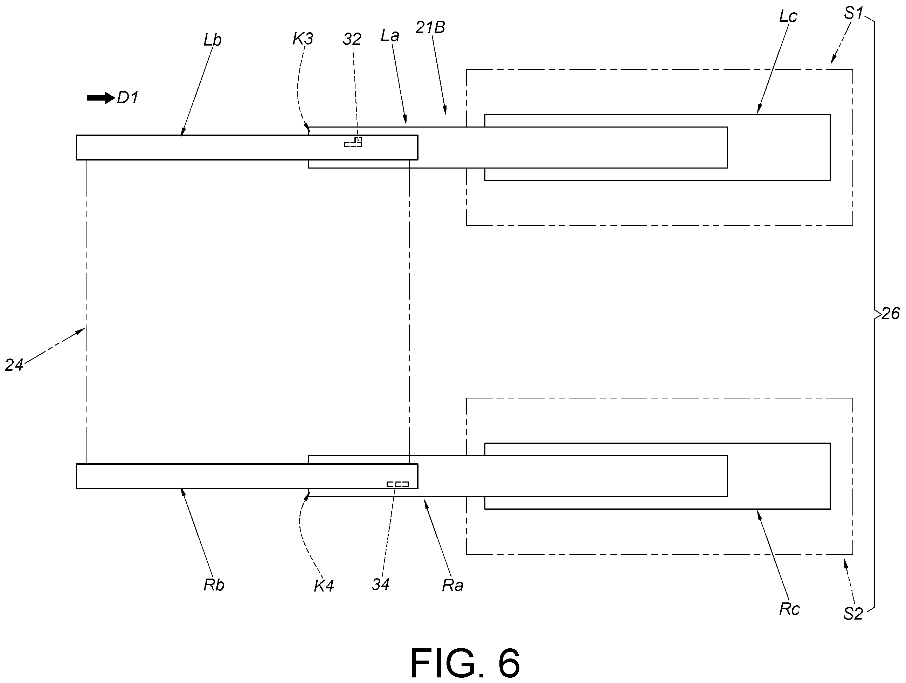

Referring to FIG. 6, the third corresponding rail Lb and the fourth corresponding rail Rb are configured to be used in conjunction with the third predetermined rail La and the fourth predetermined rail Ra in a normal condition (e.g., in a first mounting condition). More specifically, the third corresponding rail Lb and the fourth corresponding rail Rb are configured to be inserted, in the retracting direction D1 and in a detachable manner, into the third channel K3 of the third predetermined rail La and the fourth channel K4 of the fourth predetermined rail Ra from outside the third channel K3 of the third predetermined rail La and the fourth channel K4 of the fourth predetermined rail Ra respectively, thereby mounting the second object 24 to the rack 26. The inserting operation can continue until the second object 24 is in its retracted state with respect to the rack 26.

FIG. 5 and FIG. 6 show the second set of slide rail assemblies 21B used in conjunction with the second object 24 in a normal mounting condition. It can be understood that when the second set of slide rail assemblies 21B is not yet used with the second object 24 (e.g., when the slide rail products just arrives at the user end from the factory), an abnormal condition (e.g., a second mounting condition) may arise where the user mistakes (e.g., erroneously reverses) the predetermined left and right mounting positions of the third corresponding rail Lb and the fourth corresponding rail Rb and attempts to mount each of these two rails on the other's designated side. Should that happen, the third foolproof feature 32 of the third predetermined rail La and the fourth foolproof feature 34 of the fourth corresponding rail Rb will interfere with each other, preventing the fourth corresponding rail Rb from being inserted into, and hence from being coupled to, the third channel K3 of the third predetermined rail La. The prevention produces a mistake-proofing and warning effect, alerting the user to the fact that the second set of slide rail assemblies 21B is being mounted erroneously.

It can be known from the above that with the first corresponding rail L2, the second predetermined rail R1, the third predetermined rail La, and the fourth corresponding rail Rb including the first foolproof feature 28, the second foolproof feature 30, the third foolproof feature 32, and the fourth foolproof feature 34 respectively, the slide rail mechanism 20 has a foolproof mechanism that can prevent the first object 22 from being mounted at a wrong position on the rack 26 or prevent the second object 24 from being mounted at a wrong position on the rack 26. In other words, the slide rail mechanism 20 ensures that the first object 22 and the second object 24 will be mounted at their respective correct positions on the rack 26.

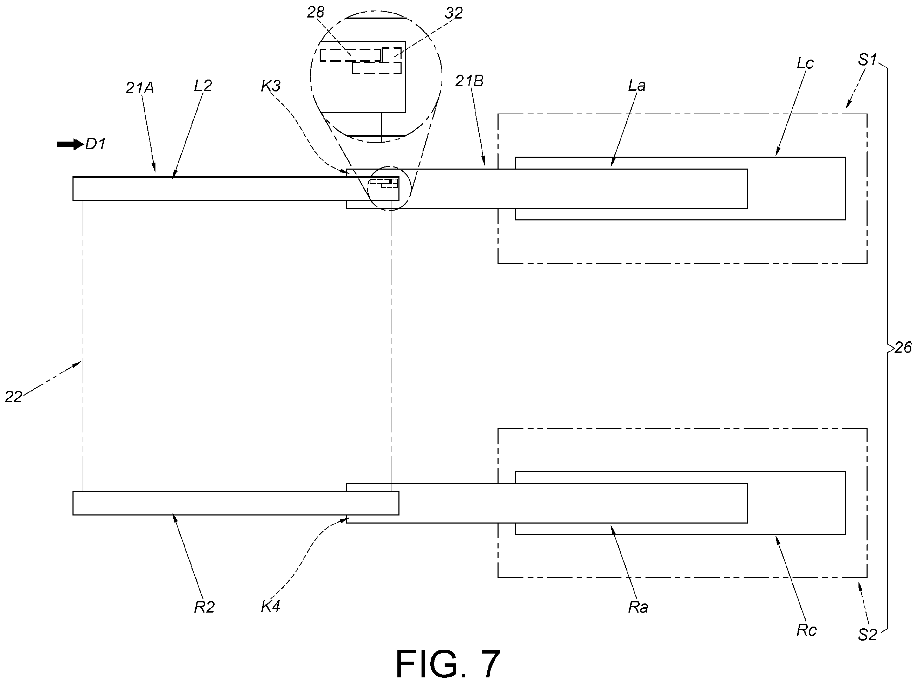

In FIG. 7, the third stationary rail Lc is fixed on the first side S1 of the rack 26, the third predetermined rail La is at its extended position with respect to the third stationary rail Lc, the fourth stationary rail Rc is fixed on the second side S2 of the rack 26, and the fourth predetermined rail Ra is at its extended position with respect to the fourth stationary rail Rc.

The first foolproof feature 28 of the first corresponding rail L2 and the third foolproof feature 32 of the third predetermined rail La can prevent the first object 22 from being mounted at a wrong position on the rack 26.

More specifically, in the course in which the first object 22 is mounted by inserting the first corresponding rail L2 and the second corresponding rail R2 of the first set of slide rail assemblies 21A along the retracting direction D1 into the third channel K3 of the third predetermined rail La and the fourth channel K4 of the fourth predetermined rail Ra of the second set of slide rail assemblies 21B from outside the third channel K3 of the third predetermined rail La and the fourth channel K4 of the fourth predetermined rail Ra respectively, the first foolproof feature 28 of the first corresponding rail L2 and the third foolproof feature 32 of the third predetermined rail La interfere with each other (e.g., are blocked by each other) to prevent the first object 22 from being mounted to the rack 26, and in doing so, the aforesaid foolproof features produce a mistake-proofing effect and alert the user to the fact that the first object 22 is being mounted at a wrong position on the rack 26.

The first object 22 is mounted at the correct position on the rack 26 only when the first object 22 is mounted to the rack 26 in such a way that the first corresponding rail L2 and the second corresponding rail R2 of the first set of slide rail assemblies 21A are inserted along the retracting direction D1 into the first channel K1 of the first predetermined rail L1 and the second channel K2 of the second predetermined rail R1 of the first set of slide rail assemblies 21A from outside the first channel K1 of the first predetermined rail L1 and the second channel K2 of the second predetermined rail R1 respectively (see FIG. 4).

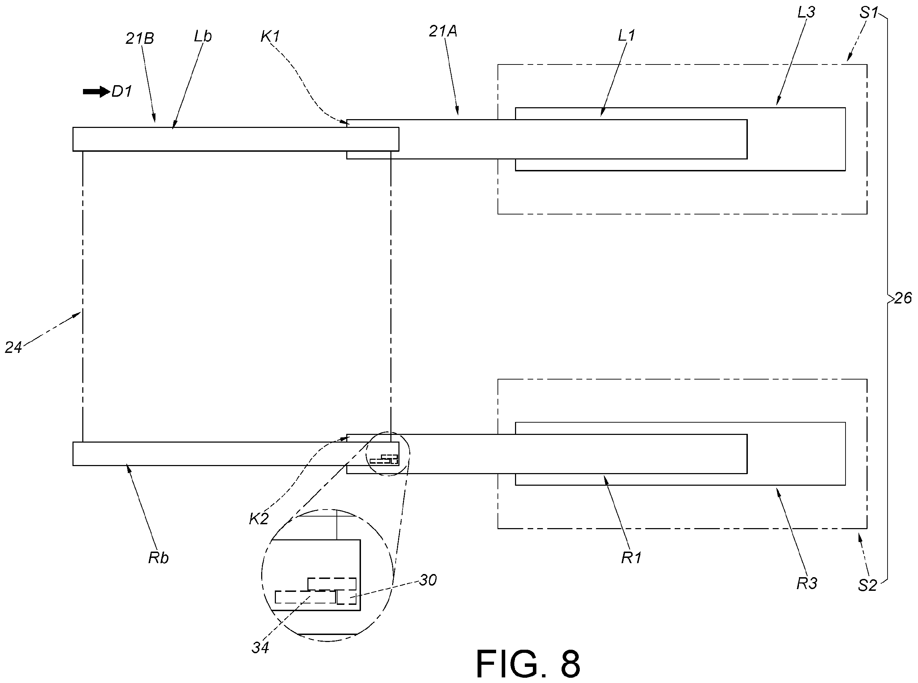

In FIG. 8, the first stationary rail L3 is fixed on the first side S1 of the rack 26, the first predetermined rail L1 is at its extended position with respect to the first stationary rail L3, the second stationary rail R3 is fixed on the second side S2 of the rack 26, and the second predetermined rail R1 is at its extended position with respect to the second stationary rail R3.

The fourth foolproof feature 34 of the fourth corresponding rail Rb and the second foolproof feature 30 of the second predetermined rail R1 can prevent the second object 24 from being mounted at a wrong position on the rack 26.

More specifically, in the course in which the second object 24 is mounted by inserting the third corresponding rail Lb and the fourth corresponding rail Rb of the second set of slide rail assemblies 21B along the retracting direction D1 into the first channel K1 of the first predetermined rail L1 and the second channel K2 of the second predetermined rail R1 of the first set of slide rail assemblies 21A from outside the first channel K1 of the first predetermined rail L1 and the second channel K2 of the second predetermined rail R1 respectively, the fourth foolproof feature 34 of the fourth corresponding rail Rb and the second foolproof feature 30 of the second predetermined rail R1 interfere with each other (e.g., are blocked by each other) to prevent the second object 24 from being mounted to the rack 26, and in doing so, the aforesaid foolproof features produce a mistake-proofing effect and alert the user to the fact that the second object 24 is being mounted at a wrong position on the rack 26.

The second object 24 is mounted at the correct position on the rack 26 only when the second object 24 is mounted to the rack 26 in such a way that the third corresponding rail Lb and the fourth corresponding rail Rb of the second set of slide rail assemblies 21B are inserted along the retracting direction D1 into the third channel K3 of the third predetermined rail La and the fourth channel K4 of the fourth predetermined rail Ra of the second set of slide rail assemblies 21B from outside the third channel K3 of the third predetermined rail La and the fourth channel K4 of the fourth predetermined rail Ra respectively (see FIG. 6).

Referring to FIG. 4, it can be known from the above that in the course in which the first corresponding rail L2 is inserted along the retracting direction D1 into the first channel K1 of the first predetermined rail L1 from outside the first channel K1 of the first predetermined rail L1, the first foolproof feature 28 of the first corresponding rail L2 does not interfere with the first predetermined rail L1, so the first corresponding rail L2 can be mounted to the first predetermined rail L1. Similarly, in the course in which the second corresponding rail R2 is inserted along the retracting direction D1 into the second channel K2 of the second predetermined rail R1 from outside the second channel K2 of the second predetermined rail R1, the second corresponding rail R2 does not interfere with the second foolproof feature 30 of the second predetermined rail R1, so the second corresponding rail R2 can be mounted to the second predetermined rail R1.

By contrast, in the course in which the first corresponding rail L2 is inserted along the retracting direction D1 into the third channel K3 of the third predetermine rail La from outside the third channel K3 of the third predetermine rail La, the first foolproof feature 28 of the first corresponding rail L2 and the third foolproof feature 32 of the third predetermined rail La produce a mistake-proofing effect by interfering with each other to prevent the first corresponding rail L2 from being mounted to the third predetermined rail La (see FIG. 7).

Referring to FIG. 6, in the course in which the fourth corresponding rail Rb is inserted along the retracting direction D1 into the fourth channel K4 of the fourth predetermined rail Ra from outside the fourth channel K4 of the fourth predetermined rail Ra, the fourth foolproof feature 34 of the fourth corresponding rail Rb does not interfere with the fourth predetermined rail Ra, so the fourth corresponding rail Rb can be mounted to the fourth predetermined rail Ra. Similarly, in the course in which the third corresponding rail Lb is inserted along the retracting direction D1 into the third channel K3 of the third predetermined rail La from outside the third channel K3 of the third predetermined rail La, the third corresponding rail Lb does not interfere with the third foolproof feature 32 of the third predetermined rail La, so the third corresponding rail Lb can be mounted to the third predetermined rail La.

By contrast, in the course in which the fourth corresponding rail Rb is inserted along the retracting direction D1 into the second channel K2 of the second predetermine rail R1 from outside the second channel K2 of the second predetermine rail R1, the fourth foolproof feature 34 of the fourth corresponding rail Rb and the second foolproof feature 30 of the second predetermined rail R1 produce a mistake-proofing effect by interfering with each other to prevent the fourth corresponding rail Rb from being mounted to the second predetermined rail R1 (see FIG. 8).

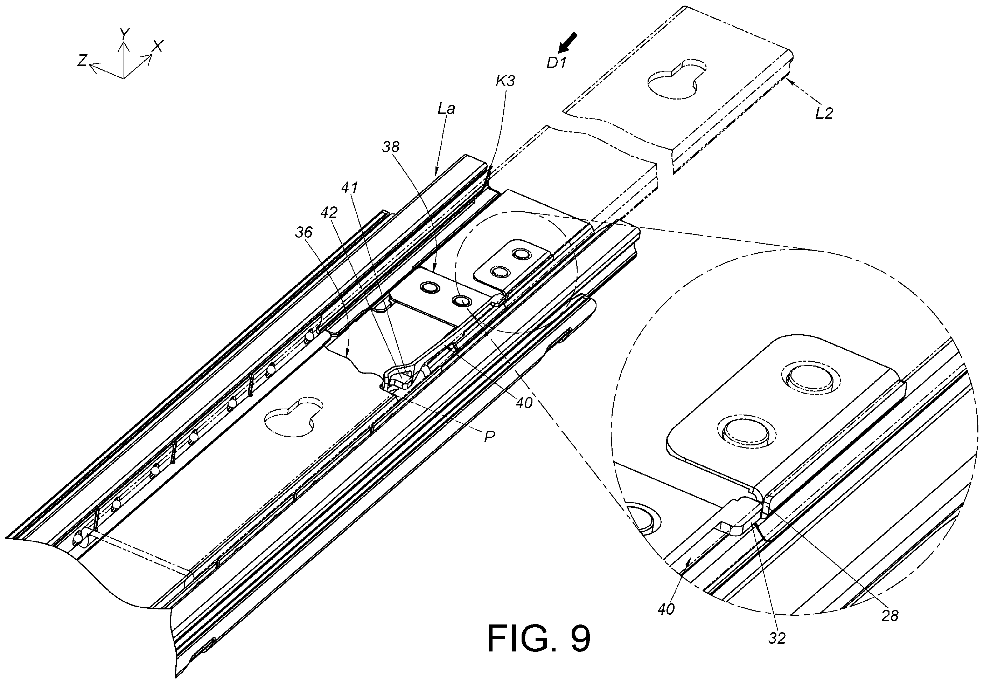

Referring to FIG. 9, each of the first foolproof feature 28, the second foolproof feature 30, the third foolproof feature 32, and the fourth foolproof feature 34 is a stationary stop portion. For example, the second foolproof feature 30 is a stop portion fixed on the second predetermined rail R1, the fourth foolproof feature 34 is a stop portion fixed on the fourth corresponding rail Rb, the first foolproof feature 28 is a stop portion fixed on the first corresponding rail L2, and the third foolproof feature 32 is a stop portion fixed on the third predetermined rail La. In other words, the first foolproof feature 28, the second foolproof feature 30, the third foolproof feature 32, and the fourth foolproof feature 34 are fixed (i.e., immovable).

By way of example, the following description is directed to only the first foolproof feature 28, which is a stop portion fixed on the first corresponding rail L2, and the third foolproof feature 32, which is a stop portion fixed on the third predetermined rail La.

In the course in which the first corresponding rail L2 is inserted along the retracting direction D1 into the third channel K3 of the third predetermined rail La from outside the third channel K3 of the third predetermined rail La, the first foolproof feature 28 of the first corresponding rail L2 and the third foolproof feature 32 of the third predetermined rail La interfere with each other (e.g., are blocked by each other) to prevent the first corresponding rail L2 from being mounted to the third predetermined rail La, and in doing so, the aforesaid foolproof features produce a mistake-proofing effect and alert the user to the fact that the first corresponding rail L2 is being mounted to a wrong (or an unintended) slide rail.

Preferably, a first rolling-ball slide-facilitating device 36 and a first positioning member 38 are arranged in the third channel K3 of the third predetermined rail La, and the first positioning member 38 allows the first rolling-ball slide-facilitating device 36 to be temporarily stopped at a predetermined position P. The first positioning member 38 is fixed on the third predetermined rail La, and the first positioning member 38 includes a first elastic arm 40 having a first positioning hole 41. The first positioning hole 41 is configured to engage with a first engaging portion 42 of the first rolling-ball slide-facilitating device 36 and thereby keep the first rolling-ball slide-facilitating device 36 at the predetermined position P.

Preferably, the third foolproof feature 32 is arranged on the first elastic arm 40, and the third foolproof feature 32 may be, for example but not limited to, a predetermined wall, a projection, or an extension section. More specifically, the third foolproof feature 32 and the first positioning hole 41 are each located at one or the other of two opposite ends (e.g., a front end and a rear end) of the first elastic arm 40; in practice, however, the third foolproof feature 32 and the first positioning hole 41 are not necessarily so located with respect to each other.

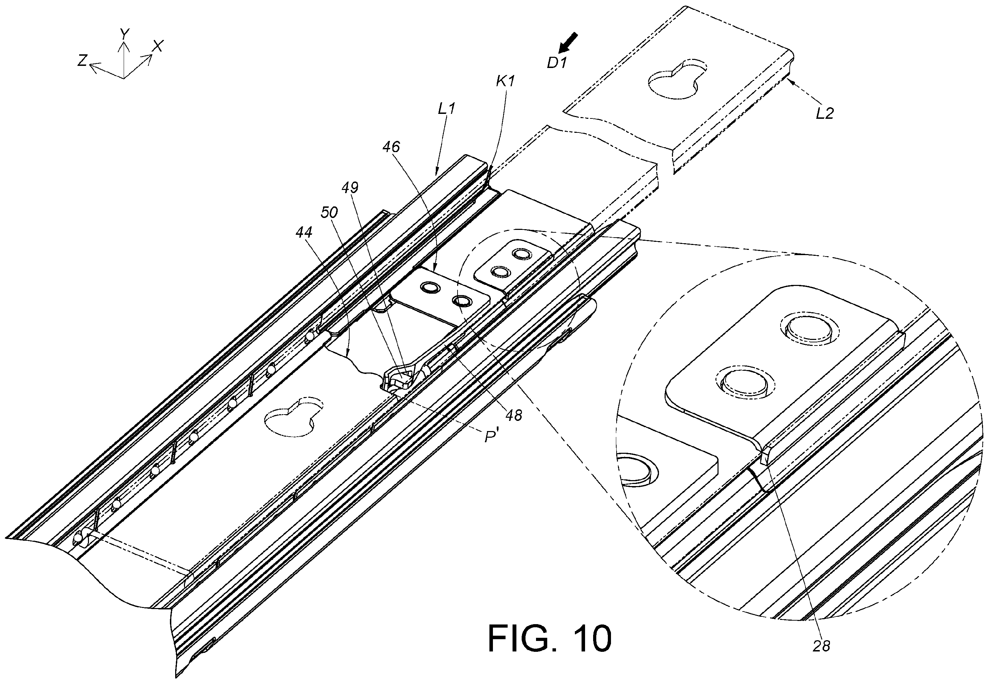

Referring to FIG. 10, a second rolling-ball slide-facilitating device 44 and a second positioning member 46 are arranged in the first channel K1 of the first predetermined rail L1, and the second positioning member 46 allows the second rolling-ball slide-facilitating device 44 to be temporarily stopped at a predetermined position P'. The second positioning member 46 is fixed on the first predetermined rail L1, and the second positioning member 46 includes a second elastic arm 48 having a second positioning hole 49. The second positioning hole 49 is configured to engage with a second engaging portion 50 of the second rolling-ball slide-facilitating device 44 and thereby keep the second rolling-ball slide-facilitating device 44 at the predetermined position P'.

It is worth mentioning that the second elastic arm 48 does not have a foolproof feature. Therefore, in the course in which the first corresponding rail L2 is inserted along the retracting direction D1 into the first channel K1 of the first predetermined rail L1 from outside the first channel K1 of the first predetermined rail L1, the first foolproof feature 28 of the first corresponding rail L2 and the second elastic arm 48 on the first predetermined rail L1 do not interfere with each other (e.g., are not blocked by each other), and this allows the first corresponding rail L2 to be mounted to the first predetermined rail L1 with success (see FIG. 4). The successful mounting is an indication to the user that the first corresponding rail L2 is mounted to the correct (or the intended) slide rail.

According to the above, the slide rail mechanism 20 provided by the foregoing embodiment of the present invention preferably has the following features:
1. With the first corresponding rail L2, the second predetermined rail R1, the third predetermined rail La, and the fourth corresponding rail Rb including the first foolproof feature 28, the second foolproof feature 30, the third foolproof feature 32, and the fourth foolproof feature 34 respectively, the slide rail mechanism 20 has a foolproof mechanism for preventing the first object 22 from being mounted at a wrong position on the rack 26 or preventing the second object 24 from being mounted at a wrong position on the rack 26. In other words, the foolproof mechanism ensures that the first object 22 and the second object 24 will be mounted at their respective correct positions on the rack 26.
2. The first predetermined rail L1 and the first corresponding rail L2 (along with the first stationary rail L3) jointly constitute the first-side slide rail device of the first set of slide rail assemblies 21A (e.g., the left-side slide rail device of the first set of slide rail assemblies 21A).
   The second predetermined rail R1 and the second corresponding rail R2 (along with the second stationary rail R3) jointly constitute the second-side slide rail device of the first set of slide rail assemblies 21A (e.g., the right-side slide rail device of the first set of slide rail assemblies 21A).
   The third predetermined rail La and the third corresponding rail Lb (along with the third stationary rail Lc) jointly constitute the first-side slide rail device of the second set of slide rail assemblies 21B (e.g., the left-side slide rail device of the second set of slide rail assemblies 21B).
   The fourth predetermined rail Ra and the fourth corresponding rail Rb (along with the fourth stationary rail Rc) jointly constitute the second-side slide rail device of the second set of slide rail assemblies 21B (e.g., the right-side slide rail device of the second set of slide rail assemblies 21B).
   With the first corresponding rail L2, the second predetermined rail R1, the third predetermined rail La, and the fourth corresponding rail Rb including the first foolproof feature 28, the second foolproof feature 30, the third foolproof feature 32, and the fourth foolproof feature 34 respectively, it is ensured that the slide rails of the first set of slide rail assemblies 21A and of the second set of slide rail assemblies 21B will be correctly mounted with respect to one another. For example, the first corresponding rail L2 of the first set of slide rail assemblies 21A is kept from being mounted to (e.g., inserted into) an unintended slide rail (e.g., the third predetermined rail La of the second set of slide rail assemblies 21B), and the fourth corresponding rail Rb of the second set of slide rail assemblies 21B is kept from being mounted to (e.g., inserted into) an unintended slide rail (e.g., the second predetermined rail R1 of the first set of slide rail assemblies 21A).
3. The first predetermined rail L1 and the second predetermined rail R1 of the first set of slide rail assemblies 21A are arranged on the first side S1 and the second side S2 of the rack 26 respectively and are at the first height H1 of the rack 26. The third predetermined rail La and the fourth predetermined rail Ra of the second set of slide rail assemblies 21B are arranged on the first side S1 and the second side S2 of the rack 26 respectively and are at the second height H2 of the rack 26, wherein the second height H2 is different from the first height H1.
4. The first foolproof feature 28, the second foolproof feature 30, the third foolproof feature 32, and the fourth foolproof feature 34 are all stationary (i.e., immovable) stop portions.

While the present invention has been disclosed through the foregoing preferred embodiment, the preferred embodiment is not intended to be restrictive of the invention. The scope of the patent protection sought by the applicant is defined by the appended claims.

## Claims

1. A slide rail mechanism (20), comprising:
a first set of slide rail assemblies (21A) including:
a first predetermined rail (L1);
a first corresponding rail (L2) configured for use in conjunction with the first predetermined rail (L1);
a second predetermined rail (R1); and
a second corresponding rail (R2) configured for use in conjunction with the second predetermined rail (R1); and
a second set of slide rail assemblies (21B) including:
a third predetermined rail (La);
a third corresponding rail (Lb) configured for use in conjunction with the third predetermined rail (La);
a fourth predetermined rail (Ra); and
a fourth corresponding rail (Rb) configured for use in conjunction with the fourth predetermined rail (Ra),
**characterized in**
**that** the first corresponding rail (L2) includes a first foolproof feature (28), the second predetermined rail (R1) includes a second foolproof feature (30), the third predetermined rail (La) includes a third foolproof feature (32), and the fourth corresponding rail (Rb) includes a fourth foolproof feature (34),
wherein while the first corresponding rail (L2) is being inserted into a channel (K1) of the first predetermined rail (L1) from outside the channel (K1) of the first predetermined rail (L1), the first foolproof feature (28) of the first corresponding rail (L2) does not interfere with the first predetermined rail (L1), so the first corresponding rail (L2) is allowed to be mounted to the first predetermined rail (L 1);
wherein while the first corresponding rail (L2) is being inserted into a channel (K3) of the third predetermined rail (La) from outside the channel (K3) of the third predetermined rail (La), the first foolproof feature (28) of the first corresponding rail (L2) and the third foolproof feature (32) of the third predetermined rail (La) produce a mistake-proofing effect by interfering with each other to prevent the first corresponding rail (L2) from being mounted to the third predetermined rail (La);
wherein while the fourth corresponding rail (Rb) is being inserted into a channel (K4) of the fourth predetermined rail (Ra) from outside the channel (K4) of the fourth predetermined rail (Ra), the fourth foolproof feature (34) of the fourth corresponding rail (Rb) does not interfere with the fourth predetermined rail (Ra), so the fourth corresponding rail (Rb) is allowed to be mounted to the fourth predetermined rail (Ra);
wherein while the fourth corresponding rail (Rb) is being inserted into a channel (K2) of the second predetermined rail (R1) from outside the channel (K2) of the second predetermined rail (R1), the fourth foolproof feature (34) of the fourth corresponding rail (Rb) and the second foolproof feature (30) of the second predetermined rail (R1) produce a mistake-proofing effect by interfering with each other to prevent the fourth corresponding rail (Rb) from being mounted to the second predetermined rail (R1);
wherein while the second corresponding rail (R2) is being inserted into a channel (K2) of the second predetermined rail (R1) from outside the channel (K2) of the second predetermined rail (R1), the second corresponding rail (R2) does not interfere with the second foolproof feature (30) of the second predetermined rail (R1), so the second corresponding rail (R2) is allowed to be mounted to the second predetermined rail (R1);
wherein while the third corresponding rail (Lb) is being inserted into the channel (K3) of the third predetermined rail (La) from outside the channel (K3) of the third predetermined rail (La), the third corresponding rail (Lb) does not interfere with the third foolproof feature (32) of the third predetermined rail (La), so the third corresponding rail (Lb) is allowed to be mounted to the third predetermined rail (La);
wherein while predetermined mounting positions of the first corresponding rail (L2) and the second corresponding rail (R2) are erroneously reversed, coupling of the first corresponding rail (L2) to the second predetermined rail (R1) by insertion thereinto is prevented by interference between the first foolproof feature (28) of the first corresponding rail (L2) and the second foolproof feature (30) of the second predetermined rail (R1);
wherein while predetermined mounting positions of the third corresponding rail (Lb) and the fourth corresponding rail (Rb) are erroneously reversed, coupling of the fourth corresponding rail (Rb) to the third predetermined rail (La) by insertion thereinto is prevented by interference between the third foolproof feature (32) of the third predetermined rail (La) and the fourth foolproof feature (34) of the fourth corresponding rail (Rb).

2. The slide rail mechanism (20) as claimed in claim 1, wherein a first rolling-ball slide-facilitating device (36) and a first positioning member (38) are arranged on the third predetermined rail (La), and the first positioning member (38) allows the first rolling-ball slide-facilitating device (36) to be temporarily stopped at a predetermined position (P).

3. The slide rail mechanism (20) as claimed in claim 2, wherein the first positioning member (38) is fixed on the third predetermined rail (La), the first positioning member (38) includes a first elastic arm (40) having a first positioning hole (41), and the first positioning hole (41) is configured for engaging with a first engaging portion (42) of the first rolling-ball slide-facilitating device (36) and thereby keeping the first rolling-ball slide-facilitating device (36) at the predetermined position (P).

4. The slide rail mechanism (20) as claimed in claim 3, wherein the third foolproof feature (32) is arranged on the first elastic arm (40), and the third foolproof feature (32) is a predetermined wall, a projection, or an extension section.

5. The slide rail mechanism (20) as claimed in claim 4, wherein the third foolproof feature (32) and the first positioning hole (41) are located at a front end and a rear end of the first elastic arm (40) respectively.

6. The slide rail mechanism (20) as claimed in any one of claims 2-5, wherein a second rolling-ball slide-facilitating device (44) and a second positioning member (46) are arranged on the first predetermined rail (L1), and the second positioning member (46) allows the second rolling-ball slide-facilitating device (44) to be temporarily stopped at a predetermined position (P').

7. The slide rail mechanism (20) as claimed in claim 6, wherein the second positioning member (46) is fixed on the first predetermined rail (L1), the second positioning member (46) includes a second elastic arm (48) having a second positioning hole (49), and the second positioning hole (49) is configured for engaging with a second engaging portion (50) of the second rolling-ball slide-facilitating device (44) and thereby keeping the second rolling-ball slide-facilitating device (44) at the predetermined position (P').

8. The slide rail mechanism (20) as claimed in claim 7, wherein the second elastic arm (48) does not have a foolproof feature such that while the first corresponding rail (L2) is being inserted into the first predetermined rail (L1), the first foolproof feature (28) of the first corresponding rail (L2) and the second elastic arm (48) on the first predetermined rail (L1) do not interfere with each other.

9. The slide rail mechanism (20) as claimed in any one of claims 1-8, wherein the first set of slide rail assemblies (21A) further includes a first stationary rail (L3) and a second stationary rail (R3), the first predetermined rail (L1) being movably mounted between the first corresponding rail (L2) and the first stationary rail (L3), and the second predetermined rail (R1) being movably mounted between the second corresponding rail (R2) and the second stationary rail (R3);
wherein the second set of slide rail assemblies (21B) further includes a third stationary rail (Lc) and a fourth stationary rail (Rc), the third predetermined rail (La) being movably mounted between the third corresponding rail (Lb) and the third stationary rail (Lc), and the fourth predetermined rail (Ra) being movably mounted between the fourth corresponding rail (Rb) and the fourth stationary rail (Rc).

10. The slide rail mechanism (20) as claimed in any one of claims 1-9, wherein the first predetermined rail (L1) and the third predetermined rail (La) are configured to be arranged on a first side (S1) of a rack (26), and the second predetermined rail (R1) and the fourth predetermined rail (Ra) are configured to be arranged on a second side (S2) of the rack (26);
wherein the first corresponding rail (L2) and the second corresponding rail (R2) are configured to be arranged on a first object (22), and the first corresponding rail (L2) and the second corresponding rail (R2) are configured to be inserted into the first predetermined rail (L1) and the second predetermined rail (R1) respectively in a detachable manner so as to mount the first object (22) to the rack (26);
wherein the third corresponding rail (Lb) and the fourth corresponding rail (Rb) are configured to be arranged on a second object (24), and the third corresponding rail (Lb) and the fourth corresponding rail (Rb) are configured to be inserted into the third predetermined rail (La) and the fourth predetermined rail (Ra) respectively in a detachable manner so as to mount the second object (24) to the rack (26);
wherein while the first object (22) is being mounted by inserting the first corresponding rail (L2) and the second corresponding rail (R2) into the third predetermined rail (La) and the fourth predetermined rail (Ra) respectively, the first foolproof feature (28) of the first corresponding rail (L2) and the third foolproof feature (32) of the third predetermined rail (La) produce a mistake-proofing effect by interfering with each other to prevent the first object (22) from being mounted to the rack (26);
wherein while the second object (24) is being mounted by inserting the third corresponding rail (Lb) and the fourth corresponding rail (Rb) into the first predetermined rail (L 1) and the second predetermined rail (R1) respectively, the fourth foolproof feature (34) of the fourth corresponding rail (Rb) and the second foolproof feature (30) of the second predetermined rail (R1) produce a mistake-proofing effect by interfering with each other to prevent the second object (24) from being mounted to the rack (26).

11. The slide rail mechanism (20) as claimed in claim 10, wherein the first side (S1) and the second side (S2) of the rack (26) are a left side and a right side respectively.

12. The slide rail mechanism (20) as claimed in any one of claims 10-11, wherein the first predetermined rail (L1) and the second predetermined rail (R1) are configured to be arranged on the first side (S1) and the second side (S2) of the rack (26) respectively and at a first height (H1) of the rack (26), the third predetermined rail (La) and the fourth predetermined rail (Ra) are configured to be arranged on the first side (S1) and the second side (S2) of the rack (26) respectively and at a second height (H2) of the rack (26), and the second height (H2) is different from the first height (H1).

13. The slide rail mechanism (20) as claimed in any one of claims 10-12, wherein the first predetermined rail (L1) and the second predetermined rail (R1) are configured to be arranged on the first side (S1) and the second side (S2) of the rack (26), and at the first height (H1) of the rack (26), via the first stationary rail (L3) and the second stationary rail (R3) respectively, and the third predetermined rail (La) and the fourth predetermined rail (Ra) are configured to be arranged on the first side (S1) and the second side (S2) of the rack (26), and at the second height (H2) of the rack (26), via the third stationary rail (Lc) and the fourth stationary rail (Rc) respectively.

14. The slide rail mechanism (20) as claimed in any one of claims 1-13, wherein the first foolproof feature (28) is a stop portion fixedly and immovably located on the first corresponding rail (L2), the second foolproof feature (30) is a stop portion fixedly and immovably located on the second predetermined rail (R1), the third foolproof feature (32) is a stop portion fixedly and immovably located on the third predetermined rail (La), and the fourth foolproof feature (34) is a stop portion fixedly and immovably located on the fourth corresponding rail (Rb).

## Amended claims

### Amended claims in accordance with Rule 137(2) EPC.

1. A slide rail mechanism (20), comprising:
a first set of slide rail assemblies (21A) including:
a first predetermined rail (L1);
a first corresponding rail (L2) configured for use in conjunction with the first predetermined rail (L1);
a second predetermined rail (R1); and
a second corresponding rail (R2) configured for use in conjunction with the second predetermined rail (R1); and
a second set of slide rail assemblies (21B) including:
a third predetermined rail (La);
a third corresponding rail (Lb) configured for use in conjunction with the third predetermined rail (La);
a fourth predetermined rail (Ra); and
a fourth corresponding rail (Rb) configured for use in conjunction with the fourth predetermined rail (Ra),
wherein the first corresponding rail (L2) includes a first foolproof feature (28), the second predetermined rail (R1) includes a second foolproof feature (30), the third predetermined rail (La) includes a third foolproof feature (32), and the fourth corresponding rail (Rb) includes a fourth foolproof feature (34),
wherein while the first corresponding rail (L2) is being inserted into a channel (K1) of the first predetermined rail (L1) from outside the channel (K1) of the first predetermined rail (L1), the first foolproof feature (28) of the first corresponding rail (L2) does not interfere with the first predetermined rail (L1), so the first corresponding rail (L2) is allowed to be mounted to the first predetermined rail (L1);
wherein while the first corresponding rail (L2) is being inserted into a channel (K3) of the third predetermined rail (La) from outside the channel (K3) of the third predetermined rail (La), the first foolproof feature (28) of the first corresponding rail (L2) and the third foolproof feature (32) of the third predetermined rail (La) produce a mistake-proofing effect by interfering with each other to prevent the first corresponding rail (L2) from being mounted to the third predetermined rail (La);
wherein while the fourth corresponding rail (Rb) is being inserted into a channel (K4) of the fourth predetermined rail (Ra) from outside the channel (K4) of the fourth predetermined rail (Ra), the fourth foolproof feature (34) of the fourth corresponding rail (Rb) does not interfere with the fourth predetermined rail (Ra), so the fourth corresponding rail (Rb) is allowed to be mounted to the fourth predetermined rail (Ra);
wherein while the fourth corresponding rail (Rb) is being inserted into a channel (K2) of the second predetermined rail (R1) from outside the channel (K2) of the second predetermined rail (R1), the fourth foolproof feature (34) of the fourth corresponding rail (Rb) and the second foolproof feature (30) of the second predetermined rail (R1) produce a mistake-proofing effect by interfering with each other to prevent the fourth corresponding rail (Rb) from being mounted to the second predetermined rail (R1);
wherein while the second corresponding rail (R2) is being inserted into a channel (K2) of the second predetermined rail (R1) from outside the channel (K2) of the second predetermined rail (R1), the second corresponding rail (R2) does not interfere with the second foolproof feature (30) of the second predetermined rail (R1), so the second corresponding rail (R2) is allowed to be mounted to the second predetermined rail (R1);
wherein while the third corresponding rail (Lb) is being inserted into the channel (K3) of the third predetermined rail (La) from outside the channel (K3) of the third predetermined rail (La), the third corresponding rail (Lb) does not interfere with the third foolproof feature (32) of the third predetermined rail (La), so the third corresponding rail (Lb) is allowed to be mounted to the third predetermined rail (La);
wherein while predetermined mounting positions of the first corresponding rail (L2) and the second corresponding rail (R2) are erroneously reversed, coupling of the first corresponding rail (L2) to the second predetermined rail (R1) by insertion thereinto is prevented by interference between the first foolproof feature (28) of the first corresponding rail (L2) and the second foolproof feature (30) of the second predetermined rail (R1);
wherein while predetermined mounting positions of the third corresponding rail (Lb) and the fourth corresponding rail (Rb) are erroneously reversed, coupling of the fourth corresponding rail (Rb) to the third predetermined rail (La) by insertion thereinto is prevented by interference between the third foolproof feature (32) of the third predetermined rail (La) and the fourth foolproof feature (34) of the fourth corresponding rail (Rb);
wherein the first foolproof feature (28) is a stop portion fixedly and immovably located on the first corresponding rail (L2), the second foolproof feature (30) is a stop portion fixedly and immovably located on the second predetermined rail (R1), the third foolproof feature (32) is a stop portion fixedly and immovably located on the third predetermined rail (La), and the fourth foolproof feature (34) is a stop portion fixedly and immovably located on the fourth corresponding rail (Rb).

2. The slide rail mechanism (20) as claimed in claim 1, wherein a first rolling-ball slide-facilitating device (36) and a first positioning member (38) are arranged on the third predetermined rail (La), and the first positioning member (38) allows the first rolling-ball slide-facilitating device (36) to be temporarily stopped at a predetermined position (P).

3. The slide rail mechanism (20) as claimed in claim 2, wherein the first positioning member (38) is fixed on the third predetermined rail (La), the first positioning member (38) includes a first elastic arm (40) having a first positioning hole (41), and the first positioning hole (41) is configured for engaging with a first engaging portion (42) of the first rolling-ball slide-facilitating device (36) and thereby keeping the first rolling-ball slide-facilitating device (36) at the predetermined position (P).

4. The slide rail mechanism (20) as claimed in claim 3, wherein the third foolproof feature (32) is arranged on the first elastic arm (40), and the third foolproof feature (32) is a predetermined wall, a projection, or an extension section.

5. The slide rail mechanism (20) as claimed in claim 4, wherein the third foolproof feature (32) and the first positioning hole (41) are located at a front end and a rear end of the first elastic arm (40) respectively.

6. The slide rail mechanism (20) as claimed in any one of claims 2-5, wherein a second rolling-ball slide-facilitating device (44) and a second positioning member (46) are arranged on the first predetermined rail (L1), and the second positioning member (46) allows the second rolling-ball slide-facilitating device (44) to be temporarily stopped at a predetermined position (P').

7. The slide rail mechanism (20) as claimed in claim 6, wherein the second positioning member (46) is fixed on the first predetermined rail (L1), the second positioning member (46) includes a second elastic arm (48) having a second positioning hole (49), and the second positioning hole (49) is configured for engaging with a second engaging portion (50) of the second rolling-ball slide-facilitating device (44) and thereby keeping the second rolling-ball slide-facilitating device (44) at the predetermined position (P').

8. The slide rail mechanism (20) as claimed in claim 7, wherein the second elastic arm (48) does not have a foolproof feature such that while the first corresponding rail (L2) is being inserted into the first predetermined rail (L1), the first foolproof feature (28) of the first corresponding rail (L2) and the second elastic arm (48) on the first predetermined rail (L1) do not interfere with each other.

9. The slide rail mechanism (20) as claimed in any one of claims 1-8, wherein the first set of slide rail assemblies (21A) further includes a first stationary rail (L3) and a second stationary rail (R3), the first predetermined rail (L1) being movably mounted between the first corresponding rail (L2) and the first stationary rail (L3), and the second predetermined rail (R1) being movably mounted between the second corresponding rail (R2) and the second stationary rail (R3);
wherein the second set of slide rail assemblies (21B) further includes a third stationary rail (Lc) and a fourth stationary rail (Rc), the third predetermined rail (La) being movably mounted between the third corresponding rail (Lb) and the third stationary rail (Lc), and the fourth predetermined rail (Ra) being movably mounted between the fourth corresponding rail (Rb) and the fourth stationary rail (Rc).

10. The slide rail mechanism (20) as claimed in any one of claims 1-9, wherein the first predetermined rail (L1) and the third predetermined rail (La) are configured to be arranged on a first side (S1) of a rack (26), and the second predetermined rail (R1) and the fourth predetermined rail (Ra) are configured to be arranged on a second side (S2) of the rack (26);
wherein the first corresponding rail (L2) and the second corresponding rail (R2) are configured to be arranged on a first object (22), and the first corresponding rail (L2) and the second corresponding rail (R2) are configured to be inserted into the first predetermined rail (L1) and the second predetermined rail (R1) respectively in a detachable manner so as to mount the first object (22) to the rack (26);
wherein the third corresponding rail (Lb) and the fourth corresponding rail (Rb) are configured to be arranged on a second object (24), and the third corresponding rail (Lb) and the fourth corresponding rail (Rb) are configured to be inserted into the third predetermined rail (La) and the fourth predetermined rail (Ra) respectively in a detachable manner so as to mount the second object (24) to the rack (26);
wherein while the first object (22) is being mounted by inserting the first corresponding rail (L2) and the second corresponding rail (R2) into the third predetermined rail (La) and the fourth predetermined rail (Ra) respectively, the first foolproof feature (28) of the first corresponding rail (L2) and the third foolproof feature (32) of the third predetermined rail (La) produce a mistake-proofing effect by interfering with each other to prevent the first object (22) from being mounted to the rack (26);
wherein while the second object (24) is being mounted by inserting the third corresponding rail (Lb) and the fourth corresponding rail (Rb) into the first predetermined rail (L1) and the second predetermined rail (R1) respectively, the fourth foolproof feature (34) of the fourth corresponding rail (Rb) and the second foolproof feature (30) of the second predetermined rail (R1) produce a mistake-proofing effect by interfering with each other to prevent the second object (24) from being mounted to the rack (26).

11. The slide rail mechanism (20) as claimed in claim 10, wherein the first side (S1) and the second side (S2) of the rack (26) are a left side and a right side respectively.

12. The slide rail mechanism (20) as claimed in any one of claims 10-11, wherein the first predetermined rail (L1) and the second predetermined rail (R1) are configured to be arranged on the first side (S1) and the second side (S2) of the rack (26) respectively and at a first height (H1) of the rack (26), the third predetermined rail (La) and the fourth predetermined rail (Ra) are configured to be arranged on the first side (S1) and the second side (S2) of the rack (26) respectively and at a second height (H2) of the rack (26), and the second height (H2) is different from the first height (H1).

13. The slide rail mechanism (20) as claimed in any one of claims 10-12, wherein the first predetermined rail (L1) and the second predetermined rail (R1) are configured to be arranged on the first side (S1) and the second side (S2) of the rack (26), and at the first height (H1) of the rack (26), via the first stationary rail (L3) and the second stationary rail (R3) respectively, and the third predetermined rail (La) and the fourth predetermined rail (Ra) are configured to be arranged on the first side (S1) and the second side (S2) of the rack (26), and at the second height (H2) of the rack (26), via the third stationary rail (Lc) and the fourth stationary rail (Rc) respectively.
